# EUROPEAN PATENT SPECIFICATION

(11) **EP 1 867 473 B1**
(45) Date of publication and mention of the grant of the patent: **02.11.2011**
(21) Application number: 06715113.4
(22) Date of filing: 02.03.2006
(51) Int. Cl.: H01L 41/22, H01L 41/18

(54) **FUNCTIONAL COMPOSITE MATERIAL WHEREIN PIEZOELECTRIC FIBER HAVING METAL CORE IS EMBEDDED**
FUNKTIONALES VERBUNDMATERIAL MIT DARIN EINGEBETTETER EINEN METALLKERN AUFWEISENDER PIEZOELEKTRISCHER FASER
MATERIAU COMPOSITE FONCTIONNEL DANS LEQUEL UNE FIBRE PIEZOELECTRIQUE AYANT UNE AME EN METAL EST ENCASTREE

(30) Priority: 03.03.2005 JP 2005059552
(43) Date of publication of application: 19.12.2007
(73) Proprietor: National University Corporation Chiba University, Chiba, 2638522 (JP)
(72) Inventor: ASANUMA, Hiroshi,, Chiba-shi, Chiba, 2638522 (JP); TAKEDA, Naohiro,, Chiba, 2638522 (JP); SATO, Hiroshi,, 3058561 Ibaraki (JP)
(74) Representative: Schön, Christoph
(86) International application number: PCT/JP2006/304004
(87) International publication number: WO 2006/100885

(56) References cited:
- EP-A- 1 331 284
- DE-A1- 10 315 425
- DE-C1- 4 033 091
- DE-C1- 10 135 962
- JP-A- 11 142 675
- JP-A- 11 174 346

## Description

### Technical Field

The present invention relates to a functional composite material in which a piezoelectric fiber is embedded and a method for manufacturing the same.

### Background Art

Ever since a functional composite material adaptable to environmental changes by embedding various types of fiber or the like in a matrix material and transforming it into a composite material was proposed, investigations have been carried out actively toward the realization thereof.

Examples of conventional technologies of embedding a fiber in a metal matrix material and transforming it into a composite material include Patent Documents 1 and 2 described below.

Patent Document 1 described below discloses a technology of manufacturing a functional composite material with an optical fiber embedded in a metal matrix material. Furthermore, Patent Document 2 described below discloses a technology of manufacturing a functional composite material with a long-fiber reinforced composite material and short-fiber reinforced composite material embedded in a metal matrix material.

On the other hand, Patent Document 3 described below discloses a functional composite material with a PZT fiber having a metal core embedded so as to function as a quick response sensor and actuator. The PZT fiber having a metal core is a fiber with a piezoelectric material containing elements such as Pb, Zr, Ti formed around the metal core such as Pt.
Patent Document 1: Japanese Patent Laid-Open No. 2001-82918 (JP 2001-82918 A)
Patent Document 2: Japanese Patent Laid-Open No. 2002-283487 (JP 2002-283487 A)
Patent Document 3: Japanese Patent Laid-Open No. 2003-328266 (JP 2001-328266 A) corresponding to EP 1331 284 A

However, the technology described in Patent Document 1 above is designed to embed an optical fiber and not to embed a piezoelectric fiber having a metal core, and the technology described in Patent Document 2 is designed to embed a reinforced fiber and not to embed a piezoelectric fiber having a metal core. A piezoelectric fiber having a metal core is very brittle, furthermore highly reactive with metals such as aluminum and it is extremely difficult to adopt a metal as a matrix material when embedding the piezoelectric fiber having a metal core, and therefore adopting a metal as a matrix has not ever been realized. The technology described in Patent Document 3 described above also uses carbon fiber reinforced plastic as a matrix material, which is not a metal.
When a piezoelectric fiber having a metal core is used as a sensor or an actuator, the piezoelectric fiber is used with a voltage applied between the metal core inside and a conductive material outside, and therefore the voltage can be applied more effectively and therefore the function as the actuator can be expected to improve dramatically when the piezoelectric fiber is embedded in a metal material than when it is embedded in carbon fiber reinforced plastic.

Therefore, in view of the above described problems, it is an object of the present invention to provide a manufacturing method for realizing a functional composite material with a brittle piezoelectric fiber having a metal core embedded in a metal.

### Disclosure of the Invention

The method for manufacturing a functional composite material according to one means for achieving the above described object includes a step of forming an insert layer on a first metal substrate in which a groove is formed, a step of placing a piezoelectric fiber having a metal core on the first metal substrate, and a step of hot-pressing the insert layer between the first substrate and a second substrate using the second substrate. This allows, for the first time, the brittle piezoelectric fiber to be embedded in a metal matrix such as aluminum.

Furthermore, the above described means more preferably uses, but not limited to, aluminum or an alloy thereof for the first metal substrate and the second metal substrate and uses copper or an alloy thereof for the insert layer. Aluminum is a light and high-strength material and a desirable material for the actuator, and use of copper for the insert layer makes it possible to cause a eutectic point to fall below 933 K, which is the melting point of aluminum, lower the temperature of hot pressing and further reduce damage to the piezoelectric fiber.

Furthermore, the above described means more preferably deepens the depth of the groove, but not limited to, more than the diameter of the piezoelectric fiber by not less than 4 times and not more than 7 times the thickness of the insert layer. This is realized as a result of giving thought to the fact that aluminum and copper become an alloy of a eutectic composition or a composition similar thereto, reducing the thickness of the aluminum substrate. Specifically, when the copper insert layer undergoes eutectic reaction with aluminum to become an alloy in a liquid phase, the thickness of the aluminum substrate is believed to be decreased approximately 4 times that of the insert layer, and it is thereby possible to manufacture a better functional composite material by setting the depth of the groove within this range. Furthermore, setting the depth of the groove to within 7 times can prevent embrittlement (reduction of strength) caused by the insert layer remaining in the matrix as a eutectic alloy even after hot pressing, which is desirable.

In the above described means, the temperature in the hot-pressing step is preferably set to, but not limited to, higher than 853 K and lower than 893 K. This is because a temperature of 893 K or higher may lead to a rupture of the PZT fiber, while a temperature of 853 K or lower may cause a large quantity of eutectic alloy of aluminum and copper to remain around the piezoelectric fiber reducing the strength as the structural material. In this case, the pressure in the hot-pressing step is more preferably set to, but not limited to, within a range higher than 1.1 MPa and lower than 4.4 MPa and still more preferably not lower than 1.5 MPa and not higher than 4 MPa.

Furthermore, the method for manufacturing a functional composite material according to another means for achieving the above described object includes a step of forming an insert layer in a first substrate, a step of forming a groove in the first substrate in which the insert layer is formed, a step of placing a piezoelectric fiber having a metal core on the first substrate in which the groove is formed and a step of hot-pressing a second substrate and the first substrate.

Furthermore, in the above described means, the first metal substrate and the second metal substrate are more preferably made of, but not limited to, aluminum or an alloy thereof, the insert layer is made of copper or an alloy thereof and the depth of the groove is deeper than the diameter of the piezoelectric fiber placed in the groove by not less than 4 times and not more than 7 times the thickness of the insert layer.

Furthermore, in the above described means, the first metal substrate and the second metal substrate are more preferably made of, but not limited to, aluminum or an alloy thereof, the insert layer is made of copper or an alloy thereof and the temperature in the hot-pressing step is higher than 853 K and lower than 893 K.

Furthermore, in the above described means, the hot-pressing step is more preferably performed at, but not limited to, a pressure higher than 1.1 MPa and lower than 4.4 MPa and still more preferably not lower than 1.5 MPa and not higher than 4 MPa.

Furthermore, as for the functional composite material according to another means for attaining the above described object, a piezoelectric fiber having a metal core is embedded in aluminum or an alloy thereof. This allows the functions as the sensor and the actuator to be exerted.

As described above, it is possible to provide a functional composite material with a piezoelectric fiber having a metal core embedded in a metal and a method for producing the same.

### Brief Description of the Drawings

Figure 1 shows an outline of steps of manufacturing a functional composite material according to an embodiment of the present invention;
Figure 2 shows a phase diagram of aluminum and copper;
Figure 3 is a cross-sectional view of a piezoelectric fiber;
Figure 4 shows an outline of the functional composite material when a plurality of piezoelectric fibers are embedded;
Figure 5 shows a conventional technology (Patent Document 3);
Figure 6 is a cross-sectional view of the functional composite material example 1;
Figures 7(A) and 7(B) show an apparatus for an experiment for confirming the functions on the functional composite material example 1;
Figure 8 shows a measurement result by the apparatus in Figure 7; CU007PCT 6
Figures 9(A) and 9(B) show an apparatus for an experiment for confirming the functions on the functional composite material example 1;
Figure 10 shows a measurement result by the apparatus in Figure 9;
Figure 11 is a cross-sectional view of the functional composite material in Comparative Example 1;
Figure 12 is a cross-sectional view of Functional Composite Material Example 2;
Figure 13 is a cross-sectional view of another part of Functional Composite Material Example 2;
Figure 14 is a cross-sectional view of Functional Composite Material Example 3;
Figure 15 is a cross-sectional view of Functional Composite Material Example 4; and
Figure 16 is a cross-sectional view of Functional Composite Material 5.

### Description of Symbols

1 ... fiber, 2 ... insert layer, 3 ... first metal substrate, 4 ... groove, 5 ... piezoelectric fiber, 5a ... metal core, 6 ... second metal substrate, 7 ... vibration plate, 8 ... vise, 9 ... coil, 10..functional composite material

### Best Mode for Carrying Out the Invention

Hereinafter, the best mode of carrying out the present invention will be explained.

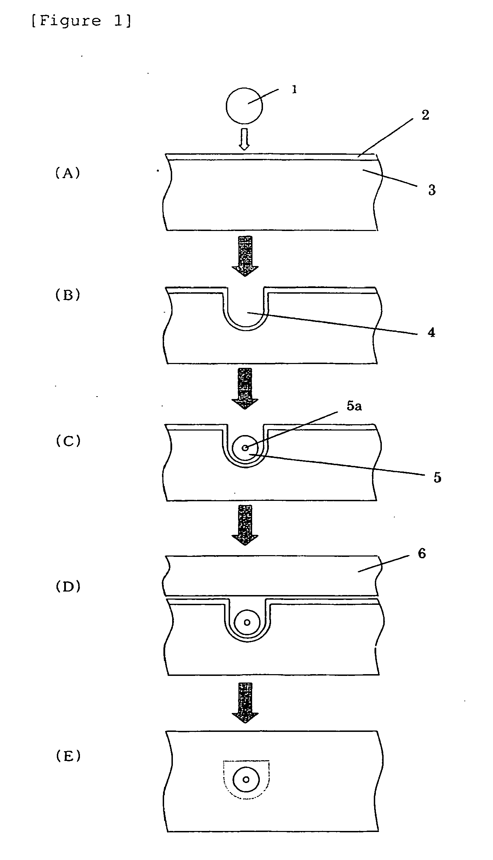

Figure 1 shows an outline of steps of manufacturing a functional composite material (hereinafter, referred to as a "functional composite material") according to this embodiment. The steps of manufacturing this functional composite material include a step of forming an insert layer 2 on a first metal substrate 3 (Figure 1(A)), a step of forming a groove 4 in the first substrate 3 on which the insert layer 2 is formed using a groove forming fiber 1 (Figure 1(B)), a step of placing a piezoelectric fiber 5 having a metal core 5a in the groove 4 of the first metal substrate 3 (Figure 1(C)) and a step of hot-pressing the first substrate 3 and a second substrate 6 using the second substrate 6 (Figure 1(D)).

For the first and second metal substrates 3, 6, other metals can also be used if they allow the piezoelectric fiber 5 having the metal core 5a to be embedded and are conductive, are not limited, but aluminum or an alloy material thereof is preferable. The present specification expresses the "first metal substrate" and the "second metal substrate", but these are naming for the pair of metal substrates for convenience' sake and have not particularly restrictive meanings. Furthermore, the present specification expresses the first and second metal substrates which are hot-pressed and bonded together as a "metal matrix material." The thicknesses of the first metal substrate 3 and the second metal substrate 6 are adjustable as appropriate considering the diameter of the piezoelectric fiber 5 to be embedded and the functions as the actuator and not limited, but the thicknesses preferably fall within a range of 0.3 mm to several tens of mm, or more preferably within a range of 0.3 mm to 2 mm from the standpoint of a high-volume and multilayered structure.

The groove 4 is formed in the first metal substrate 3 and the piezoelectric fiber 5 is placed there. Various methods may be used as the method for forming the groove 4, and one of examples is a method whereby a stainless steel fiber corresponding to the depth of the groove to be created is placed on the metal substrate and a pressure is applied thereto to form the groove 4 (Figure 1(A)). The formation of the groove 4 can be performed after forming the insert layer 2 as shown in Figure 1 or directly performed on the surface of the first metal substrate 3 before forming the insert layer 2. The "depth of the groove" in the present specification refers to the length from the surface of the first metal substrate 3 in which the groove 4 is formed to the lowest point of the groove 4 at which the groove 4 is formed and when referring to the depth of the groove 4, the thickness of the insert layer 2 is not considered. The depth of the groove 4 is adjustable as appropriate according to the diameter or the like of the piezoelectric fiber 5 embedded and not limited, but the depth is more preferably greater than the diameter of the piezoelectric fiber 5 placed in the groove 4 by not less than 4 times and not more than 7 times the thickness of the insert layer 2. The depth of the groove can be measured from the cross section of the substrate using an optical microscope or can also be measured using a laser displacement meter.

When the first and second metal substrates 3, 6 are hot pressed, the insert layer 2 reacts with those substrates and thereby functions as a bonding layer and also functions as a protection layer by filling the gap between the groove and the piezoelectric fiber.
When aluminum is used for the substrate, copper or an alloy thereof is preferable as a metal for the insert layer 2 though other metals can also be used if they are conductive, and not limited to copper or an alloy thereof.
The insert layer 2 can be formed using various methods. For example, publicly known ordinary methods such as placing a thin foil on the substrate, a sputtering method, a plating method, a vapor deposition method, an ion plating method can be used therefor. As the thickness of the insert layer, a thickness that allows the first and second metal substrates 3, 6 to be bonded together through hot pressing is required, but the thickness should not be so large as to obstruct the function as the functional material (strength as the structural material) and is preferably, but not limited to, not less than 5 µm and not more than 20 µm, for example.

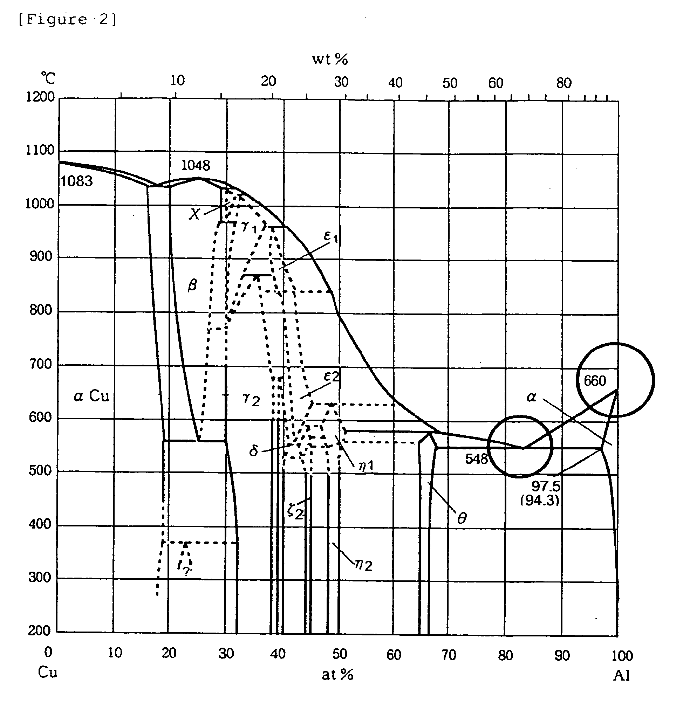

When aluminum is used for the first and second metal substrates 3, 6 and copper is used for the insert layer 2 as the above described preferable example, it is possible to perform hot pressing at a lower temperature and at a lower pressure, to suppress reaction between aluminum and the piezoelectric material, and to prevent the brittle piezoelectric fiber from being destroyed. More specifically, using aluminum and copper makes it possible to produce eutectic reaction through hot pressing, to lower the melting point (821 K), and to reduce damage to the piezoelectric fiber (Figure 2 shows a phase diagram and the center of the lower encircled part in the figure become the eutectic point).

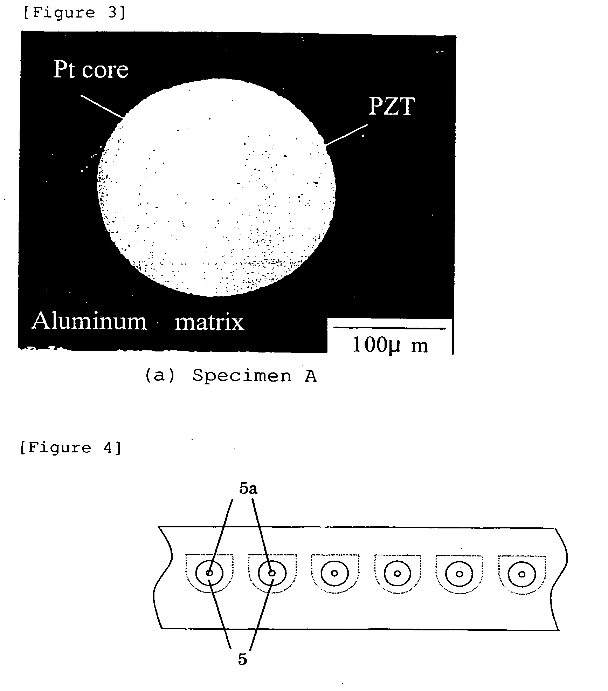

The piezoelectric fiber 5 having the metal core 5a according to this embodiment is a fiber having a structure in which a linear metal core is placed in the vicinity of the center and the periphery thereof is coated with a piezoelectric material, and is preferably, but not limited to, a PZT fiber having a metal core from the standpoint of production. The PZT fiber having a metal core is a platinum core coated with a piezoelectric material containing a metal or metals such as Pb, Zr, Ti.
The cross section of the piezoelectric fiber preferably has, but not limited to, a nearly circular shape in consideration of the distance between the metal matrix and the metal core.
Furthermore, the diameter of the piezoelectric fiber is, but not particularly limited to, not less than 50 µm and not more than 1 mm and more preferably within a range of not less than 50 µm and not more than 0.5 mm and the diameter of the metal core is more preferably within a range of not less than 10 µm and not more than 100 µm. Here, Figure 3 shows a cross section of the PZT fiber having a metal core as an example.

Next, the step of hot-pressing the first metal substrate 3 and the second metal substrate 6 between which the insert layer 2 is sandwiched is adjustable as appropriate depending on the material to be selected and the piezoelectric fiber 5a. When aluminum is used for the metal substrate and copper is used for the insert layer 2, the temperature therefor is preferably, but is not limited to, within a range higher than 853 K and lower than 893 K. As shown in Figure 2, the melting point can be lowered to 821 K which is the eutectic point when aluminum and copper are used, but too a low temperature may cause a large amount of eutectic alloy to remain in the matrix even after hot pressing and may reduce the function as the functional composite material. Therefore the temperature is preferably higher than 853 K. On the other hand, when the temperature is too high, the eutectic alloy can be effectively removed from the inside of the matrix but the peripheral metal matrix material may soften, intolerable stress may be applied to the piezoelectric fiber, leading to a destruction of the piezoelectric fiber.
Therefore the temperature is preferably less than 893 K. The pressure in this case is preferably not lower than a pressure that allows the substrate to be bonded and within a pressure range in which the piezoelectric fiber is not destroyed, preferably not lower than 1.1 MPa and not higher than 4.4 MPa, more preferably not lower than 1.5 MPa and not higher than 4 MPa. Furthermore, the duration of hot pressing is preferably within a range not less than 5 minutes and not more than one hour.

According to this embodiment as described above, a very brittle piezoelectric fiber, particularly PZT fiber can be embedded in the metal matrix.

The number of piezoelectric fibers 5 embedded in this functional composite material may be one, but may also be plural to improve the functionality as the functional composite material. This cross-sectional view is shown in Figure 4. Since this functional composite material contains the metal core 5a in the piezoelectric fiber 5 and the matrix material is also metal, distortion can be caused in the piezoelectric fiber by applying an electric field between these metals. This distortion acts on the matrix consequently and causes the matrix to operate so as to stretch or shorten the piezoelectric fiber in the direction in which the piezoelectric fiber is deformed.

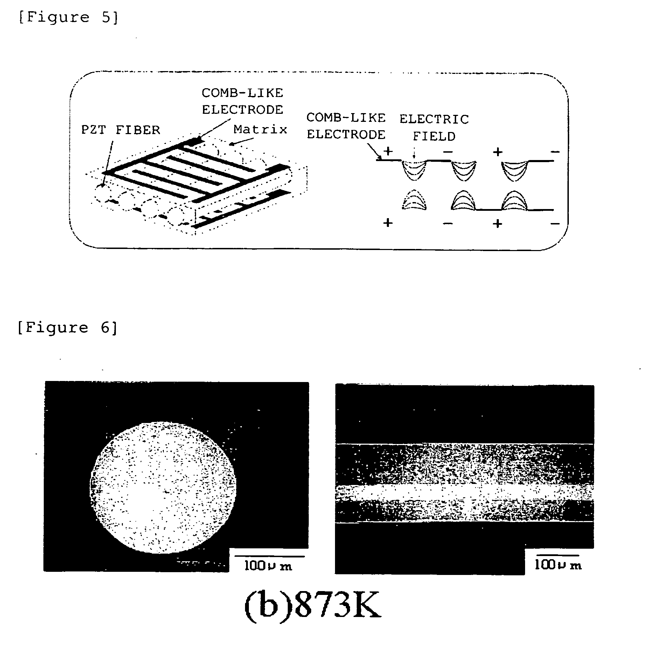

Especially, since the functional composite material described in above Patent Document 3 (see Figure 5) adopted a structure in which electrodes were arranged in a comb-like form and an electric field was applied between the comb-like electrodes and the electric field was thereby applied to the piezoelectric fiber, the area where the electric field could be applied inside the piezoelectric fiber was limited.
However, in the case of the inventive functional composite material, since the matrix material itself in which the piezoelectric fiber is embedded is a metal having extremely high conductivity, it is possible to widely apply an electric field inside the piezoelectric fiber, considerably improve efficiency and a dramatic functional improvement can be expected.

### (Functional Composite Material Example 1)

A functional composite material according to the present embodiment was actually manufactured. In this functional composite material example, aluminum was used for the first and second metal substrates and copper was used for the insert layer.

Aluminum as the first substrate was assumed to be 1.5 mm in thickness, 15 mm in length and 30 mm in width. A copper foil of 10 µm in thickness was then overlapped as the insert layer.

Next, a stainless steel fiber of 300 µm in diameter was pushed against the first substrate in which this insert layer was provided to form a groove of 250 µm in depth. The width of the groove was 300 µm.

Next, a PZT fiber of approximately 200 µm in diameter was placed in the groove and a second metal substrate made of aluminum of 1.5 mm in thickness, 15 mm in width, 30 mm in length was hot-pressed for 2.4 ks at a pressure of 2.2 MPa and at 873 K. Figure 6 shows a cross-sectional view of the resulting functional composite material. In the case of this functional composite material, the PZT fiber existed satisfactorily without being destroyed and a eutectic alloy was also removed sufficiently, resulting in a good functional composite material.

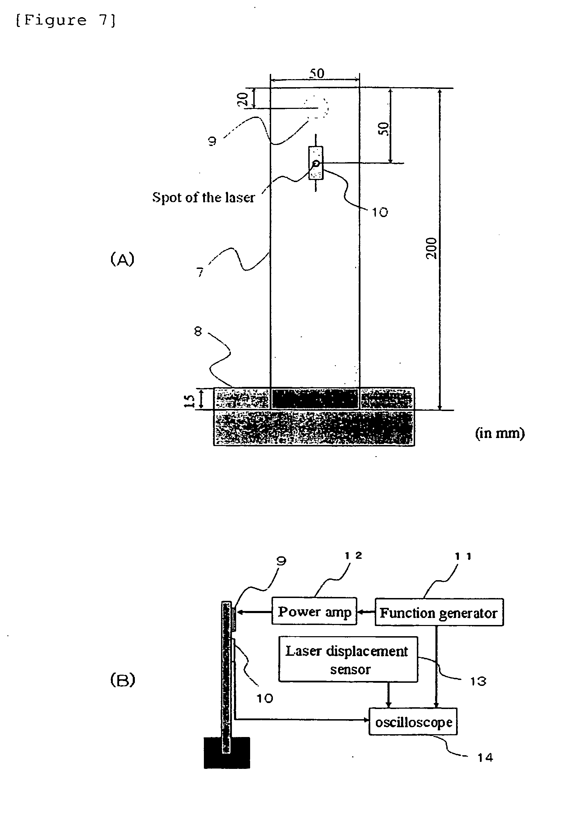

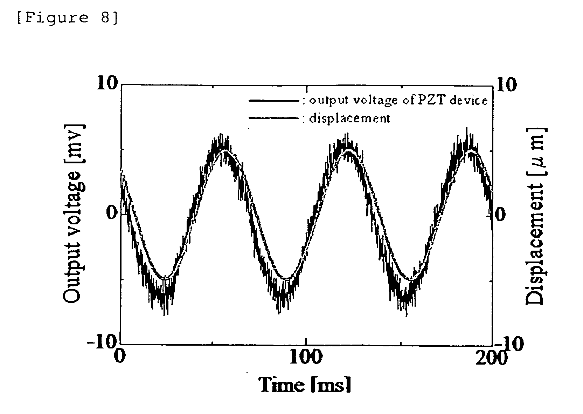

Furthermore, a confirming experiment was conducted to prove the function of the functional composite material produced here. Figures 7(A) and (B) show an outline of the apparatus for this confirming experiment. As shown in Figure 7(A), the apparatus for this confirming experiment has a vibration plate 7 (aluminum (A1050P-H24), 200 mm x 50 mm x 1 mm) and a vise 8 to fix this vibration plate 7, and a coil 9 and the functional composite material 10 produced above are further arranged on the vibration plate 7. Furthermore, as shown in Figure 7(B), an arbitrary waveform generator 11 and an amplifier 12 are connected to the coil 9. It is possible to cause the vibration plate 7 to vibrate periodically by applying a periodic voltage to the coil 9 to make it interact with a magnet placed so as to face the coil 9.
The displacement caused through vibration of the diaphragm was measured using a laser displacement meter 13, and the output of this laser displacement meter 13 and the output of the arbitrary waveform generator 11 were observed using an oscilloscope 14. Figure 8 shows the result of this measurement. A voltage having 15 Hz and amplitude of 10 V is applied to the coil. The horizontal axis in Figure 8 shows a time scale and the vertical axis shows an output (voltage).

It could be confirmed from the result of Figure 8 that the shape of the output from the laser displacement meter substantially matched the shape of the output of the functional composite material. In this way, it could be confirmed that the output of this functional composite material corresponds to the pressure from outside or the like and that this functional composite material can be made to function without impairing the electric characteristic of the piezoelectric fiber.

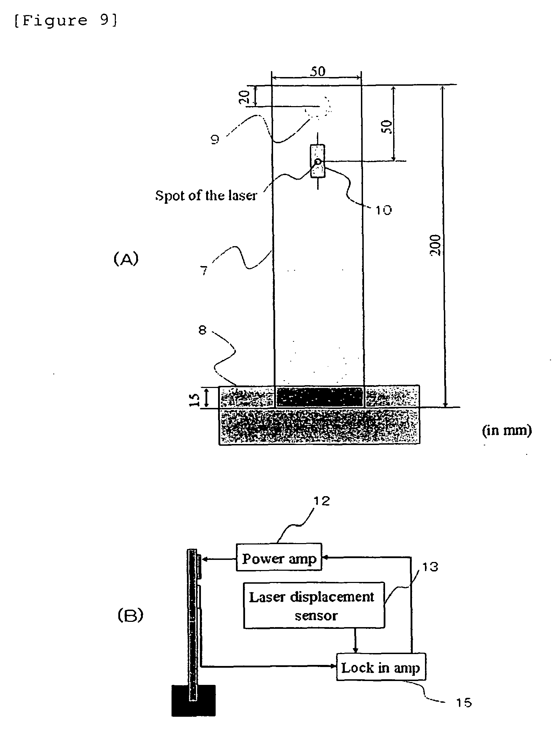

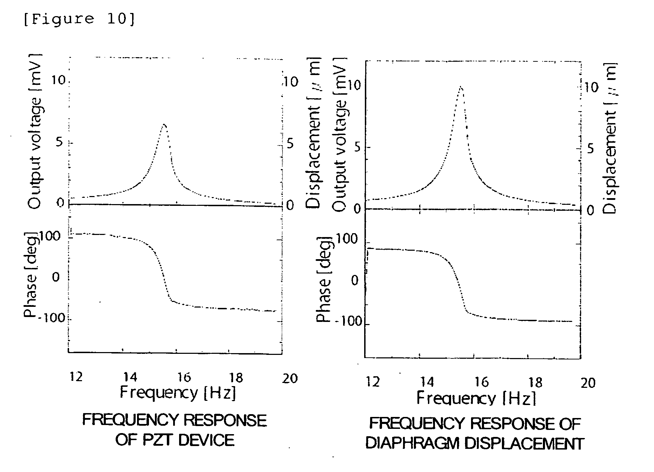

Furthermore, another confirming experiment on the functional composite material was conducted. Figures 9(A) and 9(B) show an apparatus for this confirming experiment. The apparatus for this confirming experiment is the same as that for the above described confirming experiment but differs in that it uses a lock-in amplifier 15 instead of the amplifier 12 and the oscilloscope 14 in Figure 7(B). This result is shown in Figure 10.

As shown in Figure 10, according to this functional composite material, the phase changes by 180 degrees before and after a resonance frequency (around 15.5 Hz) of this functional composite material and it could be thereby confirmed that this functional material generated an output through a piezoelectric effect not by disturbance such as an input voltage.

### (Comparative Example 1)

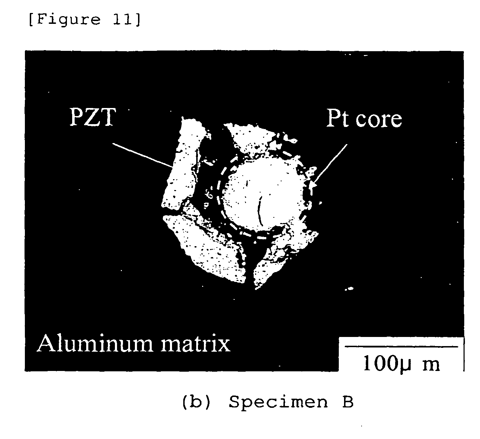

A functional composite material example with no insert layer was manufactured as a comparative example. Substantially the same structure as that of Functional Composite Material Example 1 was adopted except in that the temperature was set to 873 K and the pressure was set to 16.4 MPa. Figure 11 shows a cross-sectional view thereof. This shows that since no insert layer was formed, the PZT fiber could not withstand a high press pressure and was destroyed completely. It could be confirmed that the formation of the insert layer was indispensable.

### (Functional Composite Material Example 2)

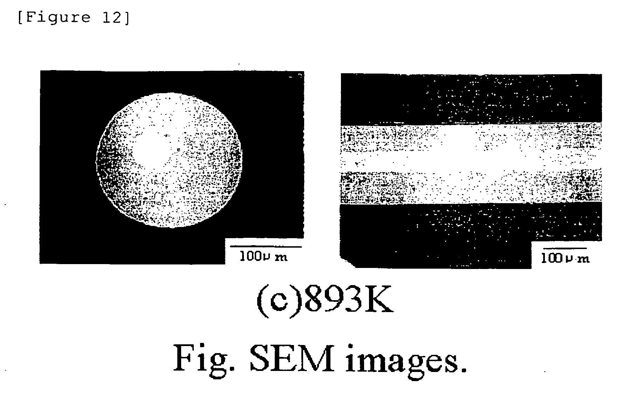

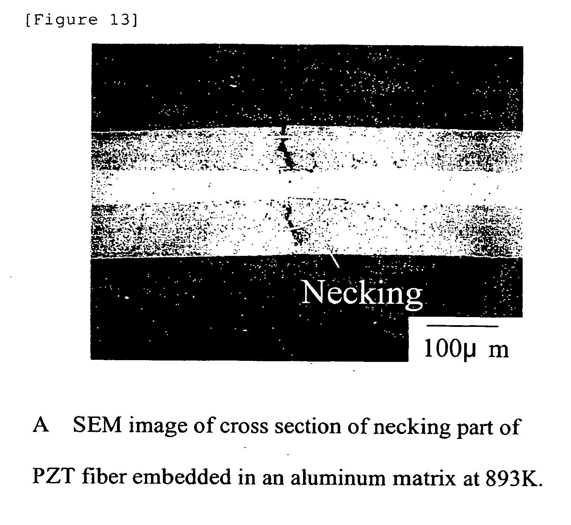

This Example 2 was manufactured under substantially the same condition as that of Functional Composite Material Example 1 except in that the temperature of hot pressing was set to 893 K. Figure 12 shows a cross-sectional view of the resulting functional composite material. Though the eutectic alloy was removed sufficiently in this functional composite material, a rupture as shown in Figure 13 was observed. This seems to be attributable to the fact that the high temperature caused the aluminum matrix to soften, and this induced a flow in the direction of the fiber and thereby induced a crack in the piezoelectric material.

### (Functional Composite Material Example 3)

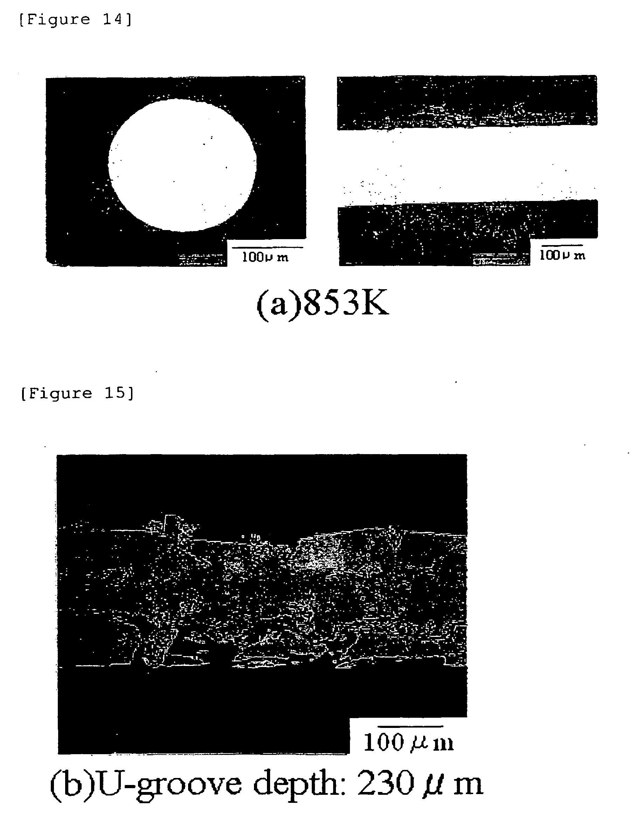

This Example 3 was manufactured under substantially the same condition as that of Functional Composite Material Example 1 except in that the temperature of hot pressing was set to 853 K. Figure 14 shows a cross-sectional view of the resulting functional composite material. Though no rupture of the PZT fiber was observed in this functional composite material, it could be confirmed that a large quantity of eutectic alloy remained in the matrix because the temperature was low.

From the above results, it could be confirmed that the hot-pressing temperature was preferably higher than 853 K and lower than 893 K.

### (Functional Composite Material Example 4) -

This example 4 was manufactured under substantially the same condition as that of Functional Composite Material Example 1 except in that the depth of the groove was set to 230 µm. Figure 15 shows a cross sectional view of the resulting functional composite material. It could be confirmed that the PZT fiber was destroyed in this functional composite material. This seems to be attributable to the fact that a eutectic alloy was formed by aluminum and copper, the surface of the aluminum substrate became a liquid phase, and the liquid phase flowed with the result that the depth of the groove decreased, the PZT fiber was directly pushed against the metal substrate and a pressure at more than a tolerable level was applied. That is, it was found that the depth of the groove is preferably larger than the diameter of the PZT fiber by more than 3 times the thickness of the insert layer.

### (Functional Composite material Example 5)

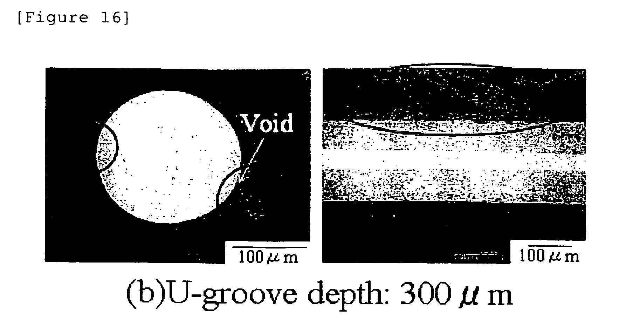

This Material 5 was manufactured under substantially the same condition as that of Functional Composite Material Example 4 except in that the depth of the groove was set to 300 µm. Figure 16 shows a cross sectional view of this functional composite material. It could be confirmed that the PZT fiber having a metal core was sound in this functional composite material. However, since the groove was deep more than necessary, voids remained around the piezoelectric fiber and moreover the eutectic alloy of aluminum and copper could not be effectively removed and allowed to remain. That is, it was found that the depth of the groove is preferably smaller than 10 times the thickness of the insert layer.

### (Functioal Composite Material Example 6)

This Material 6 was manufactured under substantially the same condition as that of Functional Composite Material Example 5 except in that the depth of the groove was set to 280 µm. It could be confirmed that the PZT fiber having a metal core was sound in this functional composite material. However, since the groove was deep more than necessary as in the case of the above described example, the eutectic alloy of aluminum and copper could not be effectively removed and allowed to remain. That is, it was found that the depth of the groove is preferably smaller than 8 times the thickness of the insert layer.

### (Functional Composite Material Example 7)

This Material 7 was manufactured under substantially the same condition as that of Functional Composite Material Example 1 except in that the hot-pressing pressure was set to 3.3 MPa. In the functional composite material, the PZT fiber existed satisfactorily without being destroyed as shown in above Figure 6, the eutectic alloy was also removed sufficiently and the material was proven to be a good functional composite material.

### (Functioal Composite Material Example 8)

This Material 8 was manufactured under substantially the same condition as that of Functional Composite Material Example 1 except in that the hot-pressing pressure was set to 4.4 MPa. It could be confirmed that the PZT fiber was destroyed in this functional composite material. This seems to be attributable to the fact that the pressure was too high and it was found that the pressure is preferably lower than 4.4 MPa.

### (Functioal Composite Material Example 9)

This Material 9 was manufactured under substantially the same condition as that of Functional Composite Material Example 1 except in that the hot-pressing pressure was set to 1.1 MPa. It could be confirmed that the eutectic alloy could not be sufficiently discharged out of the material and allowed to remain, and that voids remained around the piezoelectric fiber. This seems to be attributable to the fact that the pressure was too low and that the pressure is preferably higher than 1.1 MPa.

### (Functional Composite Material Examples 10, 11, 12)

These Materials 10, 11, 12 were manufactured under substantially the same condition as that of Functional composite Material Example 1 except in that the depth of the groove was set to 240, 260 or 270 µm. In all the functional composite materials, the PZT fiber existed satisfactorily without being destroyed as shown in above Figure 6, the eutectic alloy was also removed sufficiently and the materials were proven to be good functional composite materials.

As described above, this embodiment allows a very brittle piezoelectric fiber, PZT fiber in particular, to be embedded in the metal matrix material.

In the above described embodiments, the insert layer was formed on the first substrate, but it is also possible to form the insert layer only on the second substrate side and perform hot pressing. This prevents the insert layer from being formed in the groove and has an advantage that the adjustment of the depth of the groove becomes easier and an advantage that it is possible to reduce the remaining eutectic alloy compared to the above described embodiments. Furthermore, as another embodiment, it is also possible to form insert layers on both the first and second substrates.

### Industrial Applicability

According to the present invention, it is possible to realize a functional composite material with a piezoelectric fiber having a metal core embedded in a metal and provide a functional composite material adaptable to environmental changes. Since the functional composite material of the present invention can be used to detect and suppress vibration produced in a structure, it can be used to suppress noise. The present invention can also be used to detect cracks produced outside and inside a structure and used for health monitoring such as an advance detection of fatigue breakdown.

## Claims

1. A method for manufacturing a functional composite material, comprising:
a step of forming an insert metal layer (2) on a first metal substrate (3);
a step of forming a groove (4) in the first metal substrate (3) in which the insert metal layer (2) is formed;
a step of placing a piezoelectric fiber (5) having a metal core (5a) on the first metal substrate (3) in which the groove (4) is formed; and
a step of hot pressing a second metal substrate (6) and the first metal substrate (3).

2. A method for manufacturing a functional composite material, comprising:
a step of forming an insert metal layer (2) on a first metal substrate (3) in which a groove (4) is formed;
a step of placing a piezoelectric fiber (5) having a metal core (5a) in the first metal substrate (3); and
a step of hot pressing a second metal substrate (6) and the first metal substrate (3).

3. The method for manufacturing a functional composite material according to claim 1 or 2, wherein the first metal substrate (3) and the second metal substrate (6) are made of aluminum or an alloy thereof,
the insert metal layer (2) is made of copper or an alloy thereof, and
a depth of the groove (4) is greater than a diameter of the piezoelectric fiber (5) provided in the groove (4) by not less than 4 times and not more than 7 times the thickness of the insert metal layer (2).

4. The method for manufacturing a functional composite material according to claim 1 or 2, wherein the first metal substrate (3) and the second metal substrate (6) are made of aluminum or an alloy thereof,
the insert metal layer (2) is made of copper or an alloy thereof, and
the temperature in the step of hot pressing is higher than 853 K and lower than 893 K.

5. The method for manufacturing a functional composite material according to claim 3 or 4, wherein the pressure in the step of hot pressing is higher than 1.1 MPa and lower than 4.4 MPa.

6. The method for manufacturing a functional composite material according to claim 1 or 2, wherein the insert metal layer (2) is made of copper, and the first metal substrate (3) and the second metal substrate (6) are made of aluminum or an alloy thereof.

7. The method for manufacturing a functional composite material according to claim 6, wherein the piezoelectric fiber (5) is a PZT fiber.

8. The method for manufacturing a functional composite material according to claim 7, wherein the metal core (5a) is a platinum core.

9. A functional composite material comprising a piezoelectric fiber (5) having a metal core (5a) embedded in an aluminum substrate or an aluminum alloy substrate (3',6'), wherein the piezoelectric fiber (5) is surrounded by a layer of an alloy which is a reaction product between aluminum or an alloy thereof and copper or an alloy thereof to thereby allow sensor and/or actuator functions to be exerted.

10. The functional composite material according to claim 9, wherein the alloy is a reaction product between aluminum and copper by hot-pressing.

11. The functional composite material according to claim 9 or 10, wherein the piezoelectric fiber (5) is a PZT fiber.

12. The functional composite material according to claim 11, wherein the metal core (5a) is a platinum core.

13. The functional composite material according to claim 9 or 10 wherein more than one piezoelectric fibers (5) are embedded in an aluminum substrate or an aluminum alloy substrate (3',6').

## Patentansprüche

1. Verfahren zur Herstellung eines funktionellen Verbundmaterials, das die folgenden Stufen umfasst:
eine Stufe des Ausbildens einer Einfügungsmetallschicht (2) auf einem ersten Metallsubstrat (3);
eine Stufe des Ausbildens einer Vertiefung (4) in dem ersten Metallsubstrat (3), bei dem die Einfügungsmetallschicht (2) ausgebildet ist;
eine Stufe des Platzierens einer piezoelektrischen Faser (5), die einen Metallkern (5a) aufweist, auf dem ersten Metallsubstrat (3), bei dem die Vertiefung (4) ausgebildet ist; und
eine Stufe des Warmpressens eines zweiten Metallsubstrats (6) und des ersten Metallsubstrats (3).

2. Verfahren zur Herstellung eines funktionellen Verbundmaterials, das die folgenden Stufen umfasst:
eine Stufe des Ausbildens einer Einfügungsmetallschicht (2) auf einem ersten Metallsubstrat (3), in das eine Vertiefung (4) ausgebildet ist;
eine Stufe des Platzierens einer piezoelektrischen Faser (5), die einen Metallkern (5a) aufweist, auf dem ersten Metallsubstrat (3); und
eine Stufe eines Warmpressens eines zweiten Metallsubstrats (6) und des ersten Metallsubstrats (3).

3. Verfahren zur Herstellung eines funktionellen Verbundmaterials nach Anspruch 1 oder 2, wobei das erste Metallsubstrat (3) und das zweite Metallsubstrat (6) aus Aluminium oder einer Legierung hiervon hergestellt sind, die Einfügungsmetallschicht (2) aus Kupfer oder einer Legierung hiervon hergestellt ist und die Tiefe der Vertiefung (4) um nicht weniger als das 4-Fache und nicht mehr als das 7-Fache der Dicke der Einfügungsmetallschicht (2) größer ist als der Durchmesser der in der Vertiefung (4) vorgesehenen piezoelektrischen Faser (5).

4. Verfahren zur Herstellung eines funktionellen Verbundmaterials nach Anspruch 1 oder 2, wobei das erste Metallsubstrat (3) und das zweite Metallsubstrat (6) aus Aluminium oder einer Legierung hiervon hergestellt sind, die Einfügungsmetallschicht (2) aus Kupfer oder einer Legierung hiervon hergestellt ist und die Temperatur bei der Stufe des Warmpressens höher als 853 K und niedriger als 893 K ist.

5. Verfahren zur Herstellung eines funktionellen Verbundmaterials nach Anspruch 3 oder 4, wobei der Druck in der Stufe des Warmpressens höher als 1,1 MPa und niedriger als 4,4 MPa ist.

6. Verfahren zur Herstellung eines funktionellen Verbundmaterials nach Anspruch 1 oder 2, wobei die Einfügungsmetallschicht (2) aus Kupfer hergestellt ist und das erste Metallsubstrat (3) und das zweite Metallsubstrat (6) aus Aluminium oder einer Legierung hiervon hergestellt sind.

7. Verfahren zur Herstellung eines funktionellen Verbundmaterials nach Anspruch 6, wobei es sich bei der piezoelektrischen Faser (5) um eine PZT-Faser handelt.

8. Verfahren zur Herstellung eines funktionellen Verbundmaterials nach Anspruch 7, wobei der Metallkern (5a) ein Platinkern ist.

9. Funktionelles Verbundmaterial, das eine einen Metallkern (5a) aufweisende piezoelektrische Faser (5) umfasst, die in ein Aluminiumsubstrat oder ein Substrat aus einer Aluminiumlegierung (3',6') eingebettet ist, wobei die piezoelektrische Faser (5) von einer Legierungsschicht umgeben ist, bei der es sich um ein Reaktionsprodukt zwischen Aluminium oder einer Legierung hiervon und Kupfer oder einer Legierung hiervon handelt, um **dadurch** zu ermöglichen, dass Sensor- und/oder Aktuatorfunktionen ausgeübt werden.

10. Funktionelles Verbundmaterial nach Anspruch 9, wobei es sich bei der Legierung um ein Reaktionsprodukt zwischen Aluminium und Kupfer durch Warmpressen handelt.

11. Funktionelles Verbundmaterial nach Anspruch 9 oder 10, wobei die piezoelektrische Faser (5) eine PZT-Faser ist.

12. Funktionelles Verbundmaterial nach Anspruch 11, wobei der Metallkern (5a) ein Platinkern ist.

13. Funktionelles Verbundmaterial nach Anspruch 9 oder 10, wobei mehr als eine piezoelektrische Faser (5) in ein Aluminiumsubstrat oder ein Substrat aus einer Aluminiumlegierung (3',6') eingebettet sind.

## Revendications

1. Procédé pour fabriquer un matériau composite fonctionnel, comprenant :
une étape de formation d'une couche métallique d'insertion (2) sur un premier substrat métallique (3) ;
une étape de formation d'une rainure (4) dans le premier substrat métallique (3) dans lequel est formée la couche métallique d'insertion (2) ;
une étape de placement d'une fibre piézoélectrique (5) ayant un coeur métallique (5a) sur le premier substrat métallique (3) dans lequel est formée la rainure (4) ; et
une étape de pressage à chaud d'un deuxième substrat métallique (6) et du premier substrat métallique (3).

2. Procédé pour fabriquer un matériau composite fonctionnel, comprenant :
une étape de formation d'une couche métallique d'insertion (2) sur un premier substrat métallique (3) dans lequel est formée une rainure (4);
une étape de placement d'une fibre piézoélectrique (5) ayant un coeur métallique (5a) dans le premier substrat métallique (3) ; et
une étape de pressage à chaud d'un deuxième substrat métallique (6) et du premier substrat métallique (3).

3. Procédé pour fabriquer un matériau composite fonctionnel selon la revendication 1 ou 2, dans lequel le premier substrat métallique (3) et le deuxième substrat métallique (6) sont faits en aluminium ou en un alliage de celui-ci, la couche métallique d'insertion (2) est faite en cuivre ou en un alliage de celui-ci, et la profondeur de la rainure (4) est supérieure au diamètre de la fibre piézoélectrique (5) disposée dans la rainure (4) d'au moins 4 fois et d'au plus 7 fois l'épaisseur de la couche métallique d'insertion (2).

4. Procédé pour fabriquer un matériau composite fonctionnel selon la revendication 1 ou 2, dans lequel le premier substrat métallique (3) et le deuxième substrat métallique (6) sont faits en aluminium ou en un alliage de celui-ci, la couche métallique d'insertion (2) est faite en cuivre ou en un alliage de celui-ci, et la température dans l'étape de pressage à chaud est supérieure à 853 K et inférieure à 893 K.

5. Procédé pour fabriquer un matériau composite fonctionnel selon la revendication 3 ou 4, dans lequel la pression dans l'étape de pressage à chaud est supérieure à 1,1 MPa et inférieure à 4,4 MPa.

6. Procédé pour fabriquer un matériau composite fonctionnel selon la revendication 1 ou 2, dans lequel la couche métallique d'insertion (2) est faite en cuivre, et le premier substrat métallique (3) et le deuxième substrat métallique (6) sont faits en aluminium ou en un alliage de celui-ci.

7. Procédé pour fabriquer un matériau composite fonctionnel selon la revendication 6, dans lequel la fibre piézoélectrique (5) est une fibre de PZT.

8. Procédé pour fabriquer un matériau composite fonctionnel selon la revendication 7, dans lequel le coeur métallique (5a) est un coeur en platine.

9. Matériau composite fonctionnel comprenant une fibre piézoélectrique (5) ayant un coeur métallique (5a), encastrée dans un substrat en aluminium ou un substrat en alliage d'aluminium (3', 6'), dans lequel la fibre piézoélectrique (5) est entourée par une couche d'un alliage qui est un produit de la réaction entre de l'aluminium ou un alliage de celui-ci et du cuivre ou un alliage de celui-ci de façon à permettre ainsi à des fonctions de capteur et/ou d'actionneur d'être exercées.

10. Matériau composite fonctionnel selon la revendication 9, dans lequel l'alliage est un produit de la réaction entre de l'aluminium et du cuivre par pressage à chaud.

11. Matériau composite fonctionnel selon la revendication 9 ou 10, dans lequel la fibre piézoélectrique (5) est une fibre de PZT.

12. Matériau composite fonctionnel selon la revendication 11, dans lequel le coeur métallique (5a) est un coeur en platine.

13. Matériau composite fonctionnel selon la revendication 9 ou 10, dans lequel plusieurs fibres piézoélectriques (5) sont encastrées dans un substrat en aluminium ou un substrat en alliage d'aluminium (3', 6').
